# EUROPÄISCHE PATENTSCHRIFT

(11) **EP 2 203 755 B1**
(45) Veröffentlichungstag und Bekanntmachung des Hinweises auf die Patenterteilung: **27.02.2013**
(21) Anmeldenummer: 08803238.8
(22) Anmeldetag: 27.08.2008
(51) Int. Cl.: G01R 31/36, B60L 11/18

(54) **VERFAHREN ZUR INFORMATION EINES FAHRERS ÜBER EINE ABGABEFÄHIGKEIT EINER ANFORDERBAREN MINDESTLEISTUNG EINES ELEKTROMOTORS EINES FAHRZEUGS**
METHOD FOR INFORMING A DRIVER OF AN ABILITY OF AN ELECTRIC MOTOR IN A VEHICLE TO SUPPLY A MINIMUM AMOUNT OF POWER WHICH CAN BE REQUESTED
PROCEDE POUR INFORMER UN CONDUCTEUR SUR LA CAPACITE DE DEBITER UNE PUISSANCE MINIMALE POUVANT ETRE REQUISE D'UN MOTEUR ELECTRIQUE D'UN VEHICULE

(30) Priorität: 26.09.2007 DE 102007046222
(43) Veröffentlichungstag der Anmeldung: 07.07.2010
(73) Patentinhaber: Robert Bosch GmbH, 70442 Stuttgart (DE)
(72) Erfinder: PRICKARZ, Herbert, 70734 Fellbach (DE)
(86) Internationale Anmeldenummer: PCT/EP2008/061171
(87) Internationale Veröffentlichungsnummer: WO 2009/043640

(56) Entgegenhaltungen:
- GB-A- 2 417 567
- JP-A- 6 043 227
- JP-A- 10 126 902
- JP-A- 10 336 801

## Beschreibung

### Stand der Technik

Die Erfindung geht aus von einem Verfahren oder einer Steuereinrichtung nach Gattung der unabhängigen Ansprüche.

Bekannt sind Verfahren zur Information eines Fahrers über eine Abgabefähigkeit einer Leistung eines Elektromotors eines Fahrzeugs, bei welchen der Fahrer anhand einer Anzeige über die vorhandene Energie eines Energiespeichers des Elektromotors informiert wird. Eine solche Anzeige erfolgt üblicherweise, indem der Ladezustand des Energiespeichers des Elektromotors angezeigt wird. Eine solche Anzeige kann über ein Zeigerinstrument erfolgen. Ist der Fahrer über den Ladezustand des Energiespeichers des Elektromotors informiert, so ist es ihm möglich, eine maximale Leistungsfähigkeit des Fahrzeugantriebes in Form des Elektromotors abzuschätzen. Aus der älteren, noch nicht veröffentlichten Patentanmeldung DE 102007012305.3 ist es bekannt, dass ein Fahrer über die momentane maximale Leistungsfähigkeit des Fahrzeugantriebes informiert wird. Kennt der Fahrer die maximale Leistungsfähigkeit des Fahrzeugantriebes, so ist es ihm möglich, diese bei einer Planung oder einer Durchführung eines Fahrmanövers zu berücksichtigen, wie beispielsweise einem Überholmanöver.

Die JP 06-043227 beschreibt ein Verfahren zur Information eines Fahrers eines Fahrzeugs über eine Abgabefähigkeit einer durch den Fahrer anforderbaren Mindestleistung eines Elektromotors des Fahrzeugs, wobei eine veränderliche Anzeige eines Anzeigeelements in Abhängigkeit davon erfolgt, ob die anforderbare Mindestleistung durch den Elektromotor über eine vorgebbare Zeitdauer hinweg bereitgestellt werden kann.

### Offenbarung der Erfindung

Das erfindungsgemäße Verfahren zur Information eines Fahrers eines Fahrzeugs über eine Abgabefähigkeit einer durch den Fahrer anforderbaren Mindest-leistung eines Elektromotors des Fahrzeugs hat demgegenüber den Vorteil, dass eine veränderliche Anzeige eines Anzeigeelementes in Abhängigkeit davon erfolgt, ob die anforderbare Mindestleistung durch den Elektromotor über eine vorgebbare Zeitdauer hinweg bereitgestellt werden kann.

Bekannt sind Fahrzeuge, deren Fahrzeugantrieb einen Elektromotor aufweist. Ein solcher Fahrzeugantrieb kann beispielsweise einen Elektromotor als einzigen Motor aufweisen. Ferner sind Fahrzeugantriebe in Form von Hybridantrieben bekannt, bei welchen ein Verbrennungsmotor und ein Elektromotor zur Leistung des Fahrzeugantriebes beitragen. Zur Durchführung von Fahrmanövern, wie beispielsweise Überholmanövern, ist es möglich, dass der Fahrer kurzzeitig für eine gewisse Zeitdauer auf eine Mindestleistung des Fahrzeugantriebes zugreifen möchte, welche höher ist, als die momentan aufgebrachte Leistung des Fahrzeugantriebes. Hierdurch wird auch durch den Elektromotor des Fahrzeugantriebes eine Mindestleistungsabgabe benötigt, welches eine Mindestleistungsabgabe des Energiespeichers des Elektromotors erfordert. Ein solcher Energiespeicher eines Elektromotors in vorzugsweiser Form einer Batterie kann vorzugsweise in Form einer Hochvoltbatterie gegeben sein. Wird dem Fahrer nur der Ladezustand des Energiespeichers angezeigt, so ist es für den Fahrer nicht direkt ersichtlich, über welchen Zeitraum hinweg er auf eine Mindestleistung des Fahrzeugantriebes zugreifen kann, da er den genauen Zusammenhang zwischen Ladezustand des Energiespeichers sowie der Kennlinie der Leistungsaufnahme des Elektromotors in Abhängigkeit von der angeforderten Mindestleistung des Fahrzeugantriebes in der Regel nicht kennt. Fordert der Fahrer zur Durchführung eines Fahrmanövers eine Mindestleistung des Fahrzeugantriebes an, so ist es für ihn vorteilhaft, zu wissen, ob diese Mindestleistung über eine erste vorgebbare Zeitdauer hinweg bereitgestellt werden kann, worüber er erfindungsgemäß durch eine veränderliche Anzeige eines Anzeigelementes informiert wird.

Eine solche vorgebbare Zeitdauer ist vorzugsweise eine Mindestzeitdauer einer gewissen Anzahl von Sekunden. Beispielsweise könnte dies eine Zeitdauer von 30 Sekunden, oder auch 60 Sekunden sein. Der Fahrer ist somit darüber informiert, ob er über die vorgebbare Zeitdauer hinweg auf die Mindestleistung des Fahrzeugsantriebes zugreifen kann, wodurch er ein mögliches Fahrmanöver besser planen kann, welches zu einer erhöhten Sicherheit im Straßenverkehr führt. Es wird somit vermieden, dass die von dem Fahrer angeforderte Mindestleistung während der Durchführung des Fahrmanövers plötzlich und für ihn unvermittelt wegbricht.

Durch die in den abhängigen Ansprüchen aufgeführten Maßnahmen sind vorteilhafte Weiterbildungen und Verbesserungen des im unabhängigen Anspruch angegebenen Verfahrens möglich.

Vorzugsweise wird das Anzeigeelement in Abhängigkeit einer Zeitdauer dargestellt, über welche hinweg die anforderbare Mindestleistung durch den Elektromotor maximal bereitgestellt werden kann. Dies ist vorteilhaft, da der Fahrer hierdurch nicht nur darüber informiert wird, ob die Mindestleistung über eine vorgebbare Zeitdauer hinweg bereitgestellt werden kann, sondern ferner abschätzen kann, ob die Zeitdauer, über welche hinweg die anforderbare Mindestleistung durch den Elektromotor maximal bereitgestellt werden kann, größer als die vorgebbare Zeitdauer ist.

Vorzugsweise erfolgt eine Anzeige der Zeitdauer, über welche hinweg die anforderbare Mindestleistung durch den Elektromotor maximal bereitgestellt werden kann. Dies ist vorteilhaft, da der Fahrer hierdurch über die genaue Zeitdauer, über welche hinweg die anforderbare Mindestleistung durch den Elektromotor maximal bereitgestellt werden kann, informiert ist, so dass er die Durchführung eines möglichen Fahrmanövers noch genauer planen kann.

Insbesondere ist es möglich, dass die anforderbare Mindestleistung nur dann durch eine Eingabe des Fahrers angefordert werden kann, wenn die anforderbare Mindestleistung mindestens über die vorgebbare Zeitdauer hinweg bereitgestellt werden kann. Dieses ist vorteilhaft, da der Fahrer nur dann durch eine Eingabe die Mindestleistung anfordern kann, um beispielsweise ein Fahrmanöver durchzuführen, wenn diese Mindestleistung auch über die vorgebbare Zeitdauer hinweg bereitgestellt werden kann. Der Fahrer wird hierdurch abgehalten, die Mindestleistung dann anzufordern, wenn diese nur für einen sehr kurzen Zeitraum bereitgestellt werden kann.

Wird zu einem ersten Zeitpunkt die Mindestleistung durch den Fahrer angefordert und kann zu diesem ersten Zeitpunkt die Mindestleistung nur über eine Zeitdauer hinweg maximal bereitgestellt werden, welche die vorgebbare Zeitdauer unterschreitet, und ist zu einem zweiten, späteren Zeitpunkt die Zeitdauer, über welche hinweg maximal die Mindestleistung bereitgestellt werden kann, mindestens gleichgroß der vorgebbaren Zeitdauer, so wird dies vorzugsweise dem Fahrer angezeigt. Dies ist vorteilhaft, da in dem Fall, dass der Fahrer zu einem ersten Zeitpunkt die Mindestleistung anfordert, diese aber nicht wenigstens über die vorgebbare Zeitdauer hinweg bereitgestellt werden kann, der Fahrer zu einem späteren, zweiten Zeitpunkt darüber informiert wird, dass die Mindestleistung nun mindestens für die vorgebbare Zeitdauer bereitgestellt werden kann. Hierdurch ergibt sich der Vorteil, dass der Fahrer nach einer vergeblichen Anforderung der Mindestleistung zu einem späteren Zeitpunkt darüber informiert wird, dass er nun auf diese Mindestleistung mindestens über die vorgebbare Zeitdauer hinweg zugreifen kann, so dass er ein möglicherweise geplantes Fahrmanöver, beispielsweise ein Überholmanöver, durchführen kann.

Fordert ein Fahrer die Mindestleistung an und wird diese Mindestleistung durch einen Elektromotor bereitgestellt, so wird in dem Fall, dass die Zeitdauer, über welche hinweg die anforderbare Mindestleistung durch den Elektromotor maximal bereitgestellt werden kann, während der Bereitstellung der Mindestleistung eine zweite vorgebbare Zeitdauer unterschreitet, dies dem Fahrer angezeigt. Dies ist vorteilhaft, da in dem Fall, dass der Fahrer im Zuge der Durchführung eines Fahrmanövers auf die Mindestleistung zugreift und dass die Zeitdauer über welche hinweg die Mindestleistung weiterhin maximal bereitgestellt werden kann, eine zweite vorgebbare Zeitdauer unterschreitet, der Fahrer darüber informiert wird, dass die Mindestleistung zeitlich nur sehr begrenzt zur Verfügung steht, so dass er beispielsweise ein Fahrmanöver, insbesondere ein Überholmanöver, verändert oder abbricht.

Das erfindungsgemäße Steuergerät zur Ansteuerung einer Anzeigeeinheit zur Information eines Fahrers,eines Fahrzeugs über eine Abgabefähigkeit einer durch den Fahrer anforderbaren Mindestleistung eines Elektromotors des Fahrzeugs weist ebenfalls die zuvor genannten Vorteile des erfindungsgemäßen Verfahrens auf.

### Kurze Beschreibung der Zeichnungen

Ausführungsbeispiele der Erfindung sind in den Zeichnungen dargestellt und in der nachfolgenden Beschreibung näher erläutert.

Figur 1a, 1b, 2a, 2b, 3a, 3b, 3c, 4a, 4b und 4c
zeigen veränderliche Anzeigen eines Anzeigeelementes gemäß unterschiedlicher Ausführungsformen der Erfindung.

Figur 5a und 5b
zeigen veränderliche Anzeigen eines Anzeigeelementes in gemeinsamer Anzeige einer Zeitdauer über welche hinweg die anforderbare Mindestleistung durch den Elektromotor maximal bereitgestellt werden kann, gemäß unterschiedlicher Ausführungsbeispiele der Erfindung.

Figur 6a und 6b
zeigen gemäß weiterer Ausführungsbeispiele der Erfindung Anzeigen, anhand derer dem Fahrer angezeigt wird, dass während der Bereitstellung der Mindestleistung die Zeitdauer, über welche hinweg die anforderbare Mindestleistung durch den Elektromotor maximal bereitgestellt werden kann, eine zweite vorgebbare Zeitdauer unterschreitet.

Figur 7
zeigt eine erfindungsgemäße Steuereinrichtung zur Ansteuerung einer Anzeigeeinheit.

Figur 8, 9 und 10
zeigen jeweils eine Steuereinrichtung gemäß weiterer Ausführungsbeispiele der Erfindung.

### Ausführungsformen der Erfindung

Führt ein Fahrer ein Fahrzeug, welches einen Elektromotor als Teil des Fahrzeugantriebes aufweist, so ist es möglich, dass der Fahrer im Zuge der Durchführung eines Fahrmanövers, beispielsweise eines Überholmanövers, eine Mindestleistung des Fahrzeugantriebes anfordert, welche höher als die momentane Leistung des Fahrzeugantriebes ist. Um ein solches Fahrmanöver sicher planen und durchführen zu können, ist es für den Fahrer entscheidend zu wissen, ob die von ihm angeforderte Mindestleistung über eine vorgebbare Zeitdauer hinweg bereitgestellt werden kann. Der Fahrer kann somit einschätzen, ob der Fahrzeugantrieb die Mindestleistung über eine Zeitdauer hinweg bereitstellen kann, welche zur Durchführung des Fahrmanövers ausreicht. Erfindungsgemäß erfolgt daher eine veränderliche Anzeige eines Anzeigeelementes in Abhängigkeit davon, ob die anforderbare Mindestleistung durch den Elektromotor über eine vorgebbare Zeitdauer hinweg bereitgestellt werden kann.

Die vorgebbare Zeitdauer ist vorzugsweise fest eingestellt, wobei es sich um einen Zahlenwert von beispielsweise 30 Sekunden, 60 Sekunden oder auch 120 Sekunden handelt. Ferner ist es vorzugsweise möglich, dass der Fahrer diese vorgebbare Zeitdauer selber vorgibt, wodurch er durch die veränderliche Anzeige des Anzeigeelementes darüber informiert wird, ob die Mindestleistung über eine Zeitdauer hinweg bereitgestellt werden kann, welche seiner Präferenz entspricht.

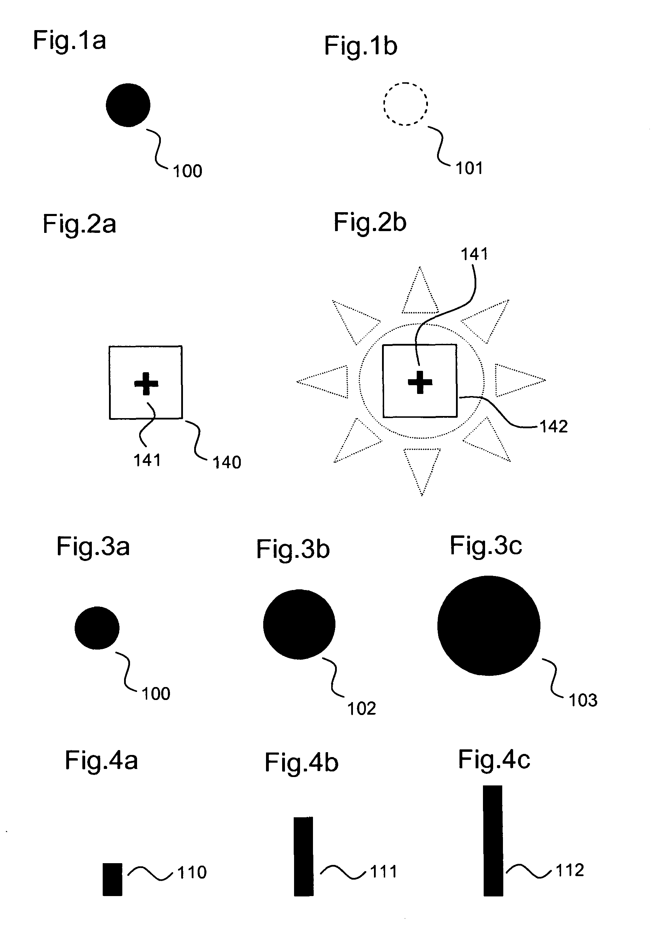

Gemäß eines Ausführungsbeispiels erfolgt die veränderliche Anzeige des Anzeigeelementes wie in Figur 1a und 1b dargestellt. Figur 1a zeigt gemäß eines Ausführungsbeispiels ein Anzeigeelement in Form eines Kreises 100 sowie Figur 1b einen Kreis 101, welcher gestrichelt ist. Vorzugsweise wird in dem Fall, dass die anforderbare Mindestleistung über die vorgebbare Zeitdauer hinweg bereitgestellt werden kann, der Kreis 100 angezeigt. In dem Fall, dass die Mindestleistung nicht über die vorgebbare Zeitdauer hinweg bereitgestellt werden kann, wird vorzugsweise der gestrichelte Kreis 101 dargestellt. Dem Fahrer ist es somit auf einfache Weise möglich, zu erkennen, ob er über die vorgebbare Zeitdauer hinweg auf die anforderbare Mindestleistung zugreifen kann. Vorzugsweise ist es möglich, anstelle des gestrichelten Kreises 101 einen Kreis in schattierter Form darzustellen. Ferner ist es vorzugsweise möglich, im Zuge der Darstellung der Anzeigeelemente 100, 101 auf Symbole zuzugreifen, welche sich durch unterschiedliche Farbgebungen und oder Formgestaltungen unterscheiden.

Figur 2a und Figur 2b zeigen eine veränderliche Anzeige eines Anzeigeelementes 140, 142 gemäß eines weiteren Ausführungsbeispiels. Vorzugsweise ist das Anzeigeelement in Form eines hinterleuchteten Kunststoffelementes 140 gegeben. Vorzugweise weist dieses hinterleuchtbare Kunststoffelement 140 ein Symbol 141 auf, welches von dem Fahrer mit einer anforderbaren Mindestleistung assoziiert wird. Kann die anforderbare Mindestleistung nicht über eine vorgebbare Zeitdauer hinweg bereitgestellt werden, so erfolgt gemäß dieses Ausführungsbeispieles keine Hinterleuchtung des Kunststoffelementes 140, wie in Figur 2a dargestellt. Für den Fall, dass die anforderbare Mindestleistung über die vorgebbare Zeitdauer hinweggestellt werden kann, wird das Kunststoffelement 142 gemäß des Ausführungsbeispieles hinterleuchtet, wie in Figur 2b dargestellt.

Zusätzlich zu den in den Figuren 1a, 1b, 2a, 2b gezeigten Ausführungsbeispiele der veränderlichen Anzeige eines Anzeigeelementes sind weitere Anzeigen eines Anzeigeelementes denkbar, bei welchen es sich beispielsweise um LCD-Displays, Warnleuchten, ein Head-Up-Display oder auch ein Zentraldisplay im Bereich der Mittelkonsole eines Fahrzeugs handelt.

Vorzugsweise wird das Anzeigeelement in Abhängigkeit einer Zeitdauer dargestellt, über welche hinweg die anforderbare Mindestleistung durch den Elektromotor maximal bereitgestellt werden kann. Ausführungsbeispiele hierzu sind in Figur 3a, 3b, 3c gegeben.

Figur 3a zeigt einen Kreis 100, welcher dem Fahrer anzeigt, dass die Mindestleistung über die vorgebbare Zeitdauer hinweg bereitgestellt werden kann. Figur 3b zeigt einen zweiten Kreis 102, welcher größer als der erste Kreis 100 ist. Figur 3c zeigt einen dritten Kreis 103, welcher größer als der erste Kreis 100 und der zweite Kreis 102 ist. Vorzugweise erfolgt die Anzeige des Kreises 100, 102, 103 derart, dass die Größe des Kreises 100, 102, 103, proportional zu der Zeitdauer ist, über welche hinweg die anforderbare Mindestleistung maximal bereitgestellt werden kann.

Gemäß eines zweiten Ausführungsbeispieles in Figur 4a, 4b, 4c erfolgt die Anzeige des Anzeigelementes in Form eines Balkens 100, 111, 112.

Figur 4a zeigt einen ersten Balken 110. Figur 4b zeigt einen zweiten Balken 111, welcher größer als der erste Balken 110 ist. Figur 4c zeigt einen dritten Balken 112, welcher größer als der erste Balken 110 und größer als der zweite Balken 111 ist. Gemäß dieses Ausführungsbeispiels erfolgt die Größe der Darstellung des Balkens 110, 111, 112 proportional zu der Zeitdauer, über welche hinweg die anforderbare Mindestleistung maximal bereitgestellt werden kann. Vorzugsweise ist es möglich, andere Symbole oder Darstellungsformen zur Darstellung des Anzeigeelementes zu verwenden. Ferner ist es möglich, zur veränderlichen Anzeige des Anzeigelementes in Abhängigkeit von der Zeitdauer, über welche hinweg die anforderbare Mindestleistung maximal bereitgestellt werden kann, auf unterschiedliche Farbgebungen zurückzugreifen. Vorzugsweise handelt es sich bei dem Anzeigeelement um einen Hebel oder einen Zeiger, welcher eine Position in Abhängigkeit zu der Zeitdauer einnimmt, über welche hinweg die anforderbare Mindestleistung maximal bereitgestellt werden kann.

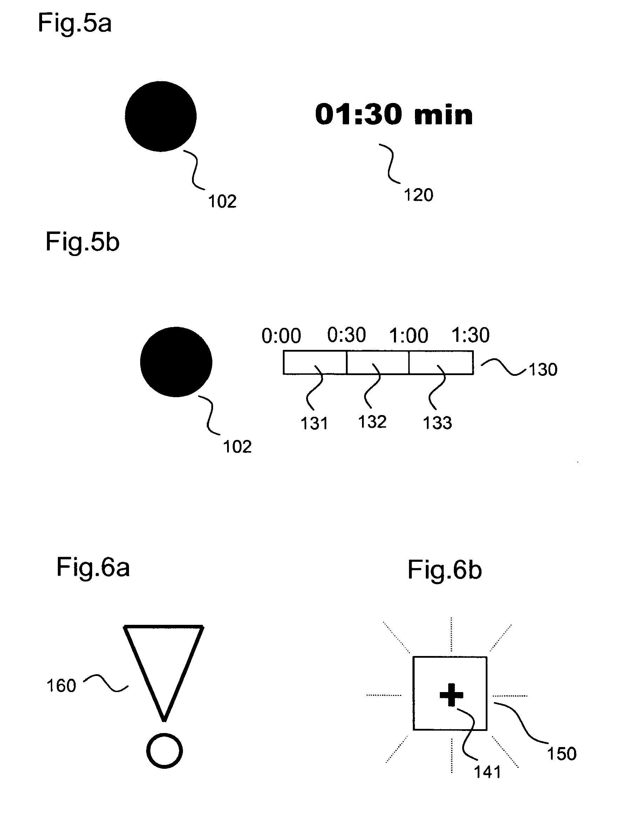

Gemäß eines weiteren Ausführungsbeispieles der Erfindung erfolgt eine Anzeige der Zeitdauer, über welche hinweg die Mindestleistung maximal bereitgestellt werden kann. Ausführungsbeispiele hierzu sind in den Figuren 5a und 5b dargestellt. Figur 5a zeigt in einem Kreis 102, welcher dem Fahrer anzeigt, dass die Mindestleistung über die vorgebbare Zeitdauer hinweg bereitgestellt werden kann. Ferner zeigt Figur 5a eine Zeitanzeige 120, welche eine Zeit von einer Minute und 30 Sekunden anzeigt. Gemäß dieses Ausführungsbeispieles wird dem Fahrer durch die Anzeige 120 angezeigt, dass er über eine Zeitdauer von 1 Minute und 30 Sekunden auf die Mindestleistung des Elektromotors zugreifen kann. Figur 5b zeigt ein weiteres Ausführungsbeispiel zur Anzeige der Zeitdauer. Gemäß Figur 5b wird der Kreis 102 angezeigt, wodurch der Fahrer darüber informiert ist, dass er über eine vorgebbare Zeitdauer hinweg auf die Mindestleistung des Elektromotors zugreifen kann. Beispielsweise handelt es sich gemäß dieses Ausführungsbeispieles bei der vorgebbaren Zeitdauer, eine Zeitdauer von 30 Sekunden. Figur 5b zeigt ferner einen Balken 130, welcher aus einem ersten Balkensegment 131, einem zweiten Balkensegment 132 sowie einem dritten Balkensegment 133 besteht. Gemäß diesem Ausführungsbeispiel erfolgt die Anzeige der Zeitdauer, über welche hinweg die Mindestleistung maximal bereitgestellt werden kann, mittels des Balkens 130. Das ersten Balkensegment 131 symbolisiert hierbei den Zeitraum von 0 bis 30 Sekunden, das zweite Balkensegment 132 symbolisiert den Zeitraum von 30 Sekunden bis 1 Minute, das dritte Balkensegment 133 symbolisiert den Zeitraum von 1 Minute bis 1 Minute und 30 Sekunden. Durch die Anzeige aller drei Balkensegmente 131, 132, 133 ist der Fahrer darüber informiert, dass er über einen Zeitraum von 1 Minute und 30 Sekunden über die Mindestleistung hinweg zugreifen kann. Weitere Formen einer Anzeige, wie die hier gezeigten Zeitanzeigen 120, 130 zur Anzeige der Zeitdauer, über welche hinweg die anforderbare Mindestleistung maximal bereitgestellt werden kann, sind beispielsweise in Form von Uhrensymbolen, veränderlich darstellbaren Kreissegmenten oder andere Anzeigeformen zur Darstellung von Zeiten denkbar.

Vorzugsweise kann durch eine Eingabe des Fahrers die anforderbare Mindestleistung nur dann angefordert werden, wenn die Mindestleistung mindestens über die vorgebbare Zeitdauer hinweg bereitgestellt werden kann. Setzt beispielsweise ein Fahrer zu einem Überholmanöver an und informiert sich zuvor nicht durch Betrachtung der veränderlichen Anzeige darüber, über welchen Zeitraum hinweg die von ihm angeforderte Mindestleistung hinweg bereitgestellt werden kann, so besteht die Gefahr, dass im Zuge eines von ihm durchgeführten Fahrmanövers die Mindestleistung unvermittelt und plötzlich wegbricht, so dass das Fahrverhalten des Fahrzeuges nicht mehr dem von ihm eingeschätzten Fahrverhalten entspricht. Wird gemäß des Ausführungsbeispieles die Mindestleistung nur dann bereitgestellt, wenn diese auch über die vorgebbare Zeitdauer hinweg bereitgestellt werden kann, so kann sich der Fahrer darüber sicher sein, dass im Zuge der Bereitstellung der Mindestleistung diese auch mindestens über die vorgebbare Zeitdauer hinweg bereitgestellt wird.

In einer Fahrsituation ist es beispielsweise möglich, dass der Fahrer die Mindestleistung anfordern möchte. Kann diese Mindestleistung jedoch nicht über die vorgebbare Zeitdauer hinweg bereitgestellt werden, so wird dem Fahrer vorzugsweise die Anforderung der Mindestleistung verweigert. Weist zu einem zweiten, späteren Zeitpunkt der Energiespeicher des Elektromotors genügend Energie auf, so dass der Elektromotor die anforderbare Mindestleistung mindestens über die vorgebbare Zeitdauer hinweg bereitstellen kann, so wird dies vorzugsweise dem Fahrer angezeigt. Befindet sich der Fahrer beispielsweise während einer Autobahnfahrt mit seinem Fahrzeug hinter einem LKW und möchte er diesen LKW durch Anforderung der Mindestleistung des Elektromotors überholen, so ist es beispielsweise möglich, dass die Batterie des Elektromotors nicht genügend Energie aufweist, damit der Elektromotor die Mindestleistung über die vorgebbare Zeitdauer hinweg bereitstellen kann. Daher wird beispielsweise dem Fahrer die Anforderung der Mindestleistung verweigert, so dass er nicht verleitet wird, das Überholmanöver einzuleiten, da im Zuge der Durchführung des Überholmanövers die Mindestleistung möglicherweise unvermittelt wegbrechen könnte. Fährt der Fahrer nun beispielsweise längere Zeit hinter dem LKW, so kann es beispielsweise zu einer Rekuperation der Batterie des Elektromotors kommen, so dass zu einem zweiten, späteren Zeitpunkt der Elektromotor die Mindestleistung wieder über die vorgebbare Zeitdauer hinweg bereitstellen kann, so dass eine Durchführung des Überholmanövers möglich wird. Dieses wird dem Fahrer vorzugsweise angezeigt. Diese Anzeige wird vorzugsweise dem Fahrer durch ein optisches Anzeigelement angezeigt. Vorzugsweise handelt es sich hierbei um ein separates Anzeigeelement. Ferner ist es beispielsweise möglich, diese Anzeige durch eine akustische Anzeige, vorzugsweise ein Warnsignal vorzunehmen.

Möchte der Fahrer auf die anforderbare Mindestleistung zugreifen, so wird dem Fahrer erfindungsgemäß anhand einer veränderlichen Anzeige eines Anzeigeelementes angezeigt, ob die anforderbare Mindestleistung über eine vorgebbare Zeitdauer hinweg bereitgestellt werden kann. Ist dies der Fall und wird die anforderbare Mindestleistung nach der Anforderung durch den Fahrer durch den Elektromotor bereitgestellt, so ist es beispielsweise möglich, dass während der Bereitstellung der Mindestleistung sich die durch den Energiespeicher des Elektromotors zur Verfügung stehende Energie ändert. Dies bedingt beispielsweise eine Abnahme der Zeitdauer, über welche hinweg die Mindestleistung maximal bereitgestellt werden kann. Damit der Fahrer im Zuge eines Fahrmanövers, also während der Bereitstellung der Mindestleistung, auf ein bevorstehendes Ausbleiben der Mindestleistung aufmerksam gemacht wird, wird in dem Fall, dass während der Bereitstellung der Mindestleistung die Zeitdauer über welche hinweg die anforderbare Mindestleistung durch den Elektromotor maximal bereitgestellt werden kann, eine zweite vorgebbare Zeitdauer unterschreitet, dieses vorzugsweise dem Fahrer angezeigt. Eine solche Anzeige erfolgt vorzugsweise durch ein aufleuchtendes und/oder blinkendes Warnsymbol, welches vorzugsweise in einer Anzeigeeinheit dargestellt wird oder in Form einer Warnleuchte erfolgt.

Ausführungsbeispiele einer solchen Anzeige sind in Figur 6a und 6b gegeben. Figur 6a zeigt ein Ausrufezeichen, welches Vorzugsweise auf einem LCD-Display dargestellt wird. Kommt es zu einem Unterschreiten der vorgebbaren Zeitdauer, so erfolgt vorzugsweise ein Aufleuchten des Ausrufezeichens 160. Vorzugsweise wird das Anzeigeelement 160 mittels besonderer Farbgebung dargestellt, welche auf den Fahrer warnend wirkt, beispielsweise in Form der Wagenfarbe rot. Ebenso ist es vorzugsweise möglich, das Anzeigeelement 160 blinkend darzustellen. Insbesondere erfolgt eine Anzeige der Unterschreitung der zweiten vorgebbaren Zeitdauer anhand einer alleinigen und/oder zusätzlichen akustischen Anzeige, beispielsweise in Form eines Warnsignals. Figur 6b zeigt eine Warnleuchte 150, welche vorzugweise ein Symbol 141 aufweist. Insbesondere wird das Unterschreiten der zweiten vorgebbaren Zeitdauer durch ein Aufblinken und/oder Aufleuchten der Warnleuchte 150 dem Fahrer angezeigt. Ferner wird vorzugsweise das Unterschreiten der zweiten vorgebbaren Zeitdauer durch eine akustische Anzeige, beispielsweise ein Warnsignal, angezeigt.

Die zweite vorgebbare Zeitdauer ist vorzugsweise fest auf einen Wert eingestellt, beispielsweise einen Wert von 10 Sekunden. Die zweite vorgebbare Zeitdauer ist vorzugsweise unabhängig von der ersten vorggebaren Zeitdauer. Ferner ist die zweite vorgebbare Zeitdauer vorzugsweise durch den Fahrer einstellbar. Der Fahrer entscheidet hierdurch beispielsweise selber darüber, wie groß die zweite Zeitdauer vor einem Ausbleiben der Mindestleistung ist, welche unterschritten werden muß, damit der Fahrer vor dem Ausbleiben der Mindestleistung gewarnt wird.

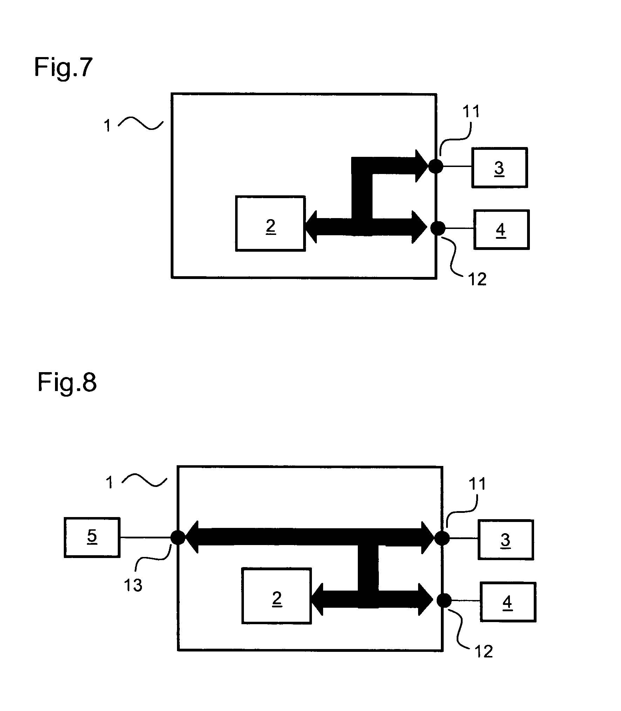

Figur 7 zeigt die erfindungsgemäße Steuereinrichtung zur Ansteuerung einer Anzeigeeinheit zur Information eines Fahrers eines Fahrzeugs über eine Abgabefähigkeit einer durch den Fahrer anforderbaren Mindestleistung eines Elektromotors des Fahrzeugs.

Die erfindungsgemäße Steuereinrichtung 1 weist eine Recheneinheit 2 auf sowie eine erste Schnittstelle 11 zu einer Anzeigeeinheit 3 als auch eine zweite Schnittstelle 12 zu einem Energiespeicher 4 eines Elektromotors eines Fahrzeugs. Die erfindungsgemäße Steuereinrichtung 1 ist dadurch gekennzeichnet, dass die Steuereinrichtung 1 die Anzeigeeinheit 3 derart ansteuert, dass eine veränderliche Anzeige eines Anzeigeelementes in Abhängigkeit davon erfolgt, ob die anforderbare Mindestleistung durch den Elektromotor über eine vorgebbare Zeitdauer hinweg bereitgestellt werden kann. Die Steuereinrichtung 1 greift hierzu über die zweite Schnittstelle 12 auf den Energiespeicher 4 des Elektromotors zu und misst beispielsweise den Ladezustand des Energiespeichers 4. Vorzugsweise bestimmt die Steuereinrichtung 1 über die Schnittstelle 12 weiterhin eine Betriebstemperatur des Energiespeichers 4. Die vorzugsweise Bestimmung der Betriebstemperatur ist beispielsweise bei einer Autobatterie vorteilhaft, da die Abgabefähigkeit einer Leistung einer Batterie temperaturabhängig ist. Weitere Kenngrößen des Energiespeichers 4 können vorzugsweise durch die Steuereinrichtung 1 über die Schnittstelle 12 bestimmt werden. Die bestimmten Kenngrö-βen des Energiespeichers 4 werden in der Steuereinrichtung 1 durch die Recheneinheit 2 ausgewertet, so dass die Recheneinheit 2 anhand dieser Auswertung der Kenngrößen auf eine Zeitdauer schließt, über welche hinweg eine anforderbare Mindestleistung durch den Elektromotor maximal bereitgestellt werden kann. Vorzugsweise ist es möglich, dass die Recheneinheit 2 hierzu Kenntnis über Kennlinien des Elektromotors besitzt, welche vorzugsweise in Form eines Softwaremoduls vorliegen oder beispielsweise durch eine hier nicht dargestellte Speichereinheit der Steuereinrichtung 1 bereitgestellt werden. Über die erste Schnittstelle 11 steuert die Steuereinrichtung 1 mittels der Recheneinheit 2 eine veränderliche Anzeige eines Anzeigeelementes in Abhängigkeit davon an, ob die anforderbare Mindestleistung durch den Elektromotor über eine vorgebbare Zeitdauer hinweg bereitgestellt werden kann. Bei dem Anzeigelement 3 handelt es sich vorzugsweise um ein LCD-Display, eine Warnleuchte, ein hinterleuchtbares Kunststoffelement, ein Head-Up-Display oder ein Zentraldisplay im Bereich der Mittelkonsole des Fahrzeugs.

Figur 8 zeigt die Steuereinrichtung 1 gemäß eines weiteren Ausführungsbeispieles der Erfindung. Die Steuereinrichtung 1 gemäß Figur 8 weist zusätzlich zu den bereits in Figur 7 dargestellten Einheiten sowie Schnittstellen eine dritte Schnittstelle 13 auf, über welche die Steuereinrichtung 1 zu einer Eingabeeinheit 5 in Verbindung steht. Diese Eingabeeinheit 5 ist zur Anforderung der anforderbaren Mindestleistung des Elektromotors durch den Fahrer geeignet. Vorzugsweise handelt es sich bei der Eingabeeinheit 5 um einen Knopf am Lenkrad oder einen Knopf im Bereich der Mittelkonsole des Fahrzeugs. Weitere Formen der Eingabeeinheit 5 zur Anforderung der Mindestleistung durch den Fahrer in Form eines Touchscreens oder in Form eines Sensors am Gaspedal sind beispielsweise möglich.

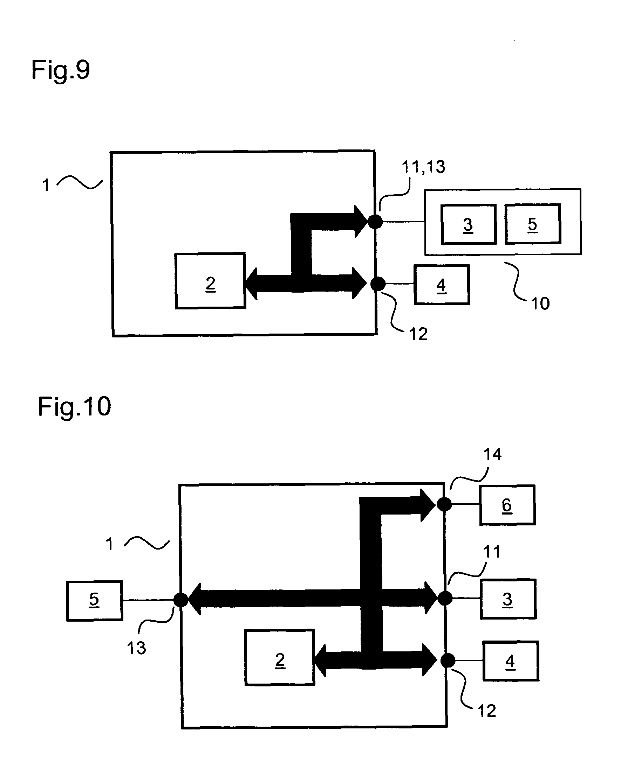

Figur 9 zeigt eine Steuereinrichtung 1 gemäß eines weiteren Ausführungsbeispiels der Erfindung. Die Steuereinrichtung 1 weist die Recheneinheit 2 auf sowie eine zweite Schnittstelle 12 zu dem Energiespeicher 4 des Elektromotors. Gemäß dieses Ausführungsbeispieles sind die erste Schnittstelle 11 und die dritte Schnittstelle 13 als eine gemeinsame Schnittstelle ausgeführt, welche zu einer kombinierten Einheit 10 führen, in welcher die Anzeigeeinheit 3 und die Eingabeeinheit 5 als eine gemeinsame, kombinierte Einheit 10 ausgeführt sind. Bei dieser kombinierten Einheit 10 kann es sich vorzugsweise um einen Knopf handeln, über welchen den Fahrer die Mindestleistung anfordern kann, welcher vorzugsweise dann hinterleuchtet ist, wenn die anforderbare Mindestleistung über eine vorgebbare Zeitdauer hinweg bereitgestellt werden kann. Durch die kombinierte Einheit 10 wird es gemäß dieses Ausführungsbeispiels dem Fahrer ermöglicht, sich sowohl zur Überprüfung der veränderlichen Anzeige des Anzeigeelementes als auch zur Eingabe einer Anforderung der Mindestleistung auf dieses eine kombinierte Element 10 zu konzentrieren.

Figur 10 zeigt eine Steuereinrichtung 1 gemäß eines weiteren Ausführungsbeispiels der Erfindung. Gemäß dieses Ausführungsbeispieles weist die Steuereinrichtung 1 zusätzlich eine vierte Schnittstelle 14 zu einer akustischen Ausgabeeinheit 6 auf. Die Steuereinrichtung 1 steuert mittels der Recheneinheit 2 über die vierte Schnittstelle 14 vorzugsweise die akustische Ausgabeeinheit 6 an, um ein Warnsignal auszugeben. Ein solches Warnsignal wird vorzugsweise in dem Fall ausgegeben, dass während der Bereitstellung der Mindestleistung die Zeitdauer, über welche hinweg die anforderbare Mindestleistung durch den Elektromotor maximal bereitgestellt werden kann, eine zweite vorgebbare Zeitdauer unterschreitet. Eine Ausgabe eines akustischen Warnsignals durch die Recheneinheit 2 über die vierte Schnittstelle 14 mittels der akustischen Ausgabeeinheit 6 ist ferner beispielsweise für weitere Fälle, in denen der Fahrer aufmerksam gemacht werden soll, möglich. Bei der akustischen Ausgabeeinheit 6 handelt es sich vorzugsweise um einen Lautsprecher, einen Buzzer, eine Hupe oder eine andere Einheit zur Ausgabe eines akustischen Signals.

## Patentansprüche

1. Verfahren zur Information eines Fahrers eines Fahrzeugs über eine Abgabefähigkeit einer durch den Fahrer anforderbaren Mindestleistung eines Elektromotors eines Fahrzeugs, wobei eine veränderliche Anzeige eines Anzeigeelements (100, 101, 102, 103, 110, 110, 112,140, 142) in Abhängigkeit davon erfolgt, ob die anforderbare Mindestleistung durch den Elektromotor über eine vorgebbare Zeitdauer hinweg bereitgestellt werden kann, **dadurch gekennzeichnet, dass** die anforderbare Mindestleistung nur dann durch eine Eingabe des Fahrers angefordert werden kann, wenn die anforderbare Mindestleistung mindestens über die vorgebbare Zeitdauer hinweg bereitgestellt werden kann.

2. Verfahren nach Anspruch 1, **dadurch gekennzeichnet, dass** das Anzeigeelement (100, 101, 102, 103, 110, 111, 112, 140, 142) in Abhängigkeit einer Zeitdauer dargestellt wird, über welche hinweg die anforderbare Mindestleistung durch den Elektromotor maximal bereitgestellt werden kann.

3. Verfahren nach Anspruch 2, **dadurch gekennzeichnet, dass** eine Anzeige der Zeitdauer (120, 130), über welche hinweg die anforderbare Mindestleistung durch den Elektromotor maximal bereitgestellt werden kann, erfolgt.

4. Verfahren nach Anspruch 3, **dadurch gekennzeichnet, dass** zu einem ersten Zeitpunkt die Mindestleistung durch den Fahrer angefordert wird, dass zu dem ersten Zeitpunkt die Mindestleistung über eine Zeitdauer hinweg maximal bereitgestellt werden kann, welche die vorgebbare Zeitdauer unterschreitet, und dass in dem Fall, dass zu einem zweiten, späteren Zeitpunkt die Zeitdauer, über welche hinweg maximal die Mindestleistung bereitgestellt werden kann, mindestens gleich groß der vorgebbaren Zeitdauer ist, dies dem Fahrer angezeigt wird.

5. Verfahren nach Anspruch 1 bis 4, **dadurch gekennzeichnet, dass** die anforderbare Mindestleistung durch den Fahrer angefordert wird, dass die anforderbare Mindestleistung durch den Elektromotor bereitgestellt wird, und dass in dem Fall, dass die Zeitdauer, über welche hinweg die anforderbare Mindestleistung durch den Elektromotor maximal bereitgestellt werden kann, während der Bereitstellung der Mindestleistung eine zweite vorgebbare Zeitdauer unterschreitet, dieses dem Fahrer angezeigt wird.

6. Steuereinrichtung (1) zur Ansteuerung einer Anzeigeeinheit (3) zur Information eines Fahrers eines Fahrzeugs über eine Abgabefähigkeit einer durch den Fahrer anforderbaren Mindestleistung eines Elektromotors des Fahrzeugs, mit einer Recheneinheit (2), mit einer ersten Schnittstelle (11) zu der Anzeigeeinheit (3) mit einer zweiten Schnittstelle (12) zu einem Energiespeicher (4) eines Elektromotors eines Fahrzeugs, wobei die Steuereinrichtung (1) die Anzeigeeinheit (3) derart ansteuert, dass eine veränderliche Anzeige des Anzeigeelements (100, 101, 102, 103, 110, 111, 112, 140, 142) in Abhängigkeit davon erfolgt, ob die anforderbare Mindestleistung durch den Elektromotor über eine vorgebbare Zeitdauer hinweg bereitgestellt werden kann, **dadurch gekennzeichnet, dass** die Steuereinrichtung (1) derart ausgestaltet ist, dass die anforderbare Mindestleistung nur dann durch eine Eingabe des Fahrers angefordert werden kann, wenn die anforderbare Mindestleistung mindestens über die vorgebbare Zeitdauer hinweg bereitgestellt werden kann.

7. Steuereinrichtung nach Anspruch 6, **dadurch gekennzeichnet, dass** die Steuereinrichtung (1) eine dritte Schnittstelle (13) zu einer Eingabeeinheit (5) zur Anforderung einer Mindestleistung des Elektromotors durch den Fahrer aufweist.

## Claims

1. Method for informing a driver of a vehicle about an output capability for a minimum power that can be requested by the driver from an electric motor in a vehicle, wherein a display element (100, 101, 102, 103, 110, 111, 112, 140, 142) is displayed in variable fashion on the basis of whether the requestable minimum power can be provided by the electric motor over a prescribable period of time, **characterized in that** the requestable minimum power can be requested by an input from the driver only if the requestable minimum power can be provided at least over the prescribable period of time.

2. Method according to Claim 1, **characterized in that** the display element (100, 101, 102, 103, 110, 111, 112, 140, 142) is presented on the basis of a maximum period of time over which the requestable minimum power can be provided by the electric motor.

3. Method according to Claim 2, **characterized in that** the maximum period of time (120, 130) over which the requestable minimum power can be provided by the electric motor is displayed.

4. Method according to Claim 3, **characterized in that** at a first time the minimum power is requested by the driver, **in that** at the first time the minimum power can be provided over a maximum period of time which is below the prescribable period of time, and **in that** if at a second, later time the maximum period of time over which the minimum power can be provided is at least of the same magnitude as the prescribable period of time then this is displayed to the driver.

5. Method according to Claims 1 to 4, **characterized in that** the requestable minimum power is requested by the driver, **in that** the requestable minimum power is provided by the electric motor, and **in that** if the maximum period of time over which the requestable minimum power can be provided by the electric motor is below a second prescribable period of time while the minimum power is being provided then this is displayed to the driver.

6. Control device (1) for actuating a display unit (3) for informing a driver of a vehicle about an output capability for a minimum power that can be requested by the driver from an electric motor in the vehicle, having a computation unit (2), having a first interface (11) to the display unit (3), having a second interface (12) to an energy store (4) for an electric motor in a vehicle, wherein the control device (1) actuates the display unit (3) such that the display element (100, 101, 102, 103, 110, 111, 112, 140, 142) is displayed in variable fashion on the basis of whether the requestable minimum power can be provided by the electric motor over a prescribable period of time, **characterized in that** the control device (1) is designed such that the requestable minimum power can be requested by an input from the driver only if the requestable minimum power can be provided at least over the prescribable period of time.

7. Control device according to Claim 6, **characterized in that** the control device (1) has a third interface (13) to an input unit (5) for a minimum power to be requested from the electric motor by the driver.

## Revendications

1. Procédé d'information d'un conducteur d'un véhicule sur la capacité à débiter une puissance minimale d'un moteur électrique d'un véhicule, ladite puissance pouvant être requise par le conducteur, un affichage d'un élément d'affichage (100, 101, 102, 103, 110, 111, 112, 140, 142) pouvant varier en fonction de si la puissance minimale pouvant être requise peut être mise à disposition par le moteur électrique pendant une durée prédéfinie, **caractérisé en ce que** la puissance minimale pouvant être requise ne peut être requise par instruction du conducteur que lorsque la puissance minimale pouvant être requise peut être mise à disposition pendant au moins la durée prédéfinie.

2. Procédé selon la revendication 1, **caractérisé en ce que** l'élément d'affichage (100, 101, 102, 103, 110, 111, 112, 140, 142) est représenté en fonction d'une durée pendant laquelle la puissance minimale pouvant être requise peut être mise à disposition de façon maximale par le moteur électrique.

3. Procédé selon la revendication 2, **caractérisé par** la présence d'un affichage de la durée (120, 130) pendant laquelle la puissance minimale pouvant être requise peut être mise à disposition de façon maximale par le moteur électrique.

4. Procédé selon la revendication 3, **caractérisé en ce qu'**à un premier instant, la puissance minimale est requise par le conducteur, qu'au premier instant, la puissance minimale peut être mise à disposition de façon maximale pendant une durée se situant en dessous de la durée prédéfinie et que dans le cas dans lequel à un deuxième instant ultérieur, la durée pendant laquelle la puissance maximale peut être mise à disposition de façon maximale est au moins égale à la durée pouvant être prédéfinie, ceci est affiché au conducteur.

5. Procédé selon les revendications 1 à 4, **caractérisé en ce que** la puissance minimale pouvant être requise est requise par le conducteur, que la puissance minimale pouvant être requise est mise à disposition par le moteur électrique et que dans le cas dans lequel la durée pendant laquelle la puissance minimale pouvant être requise peut être mise à disposition de façon maximale par le moteur électrique lorsque la mise à disposition de la puissance minimale passe en dessous d'une deuxième durée pouvant être prédéfinie, ceci est affiché au conducteur.

6. Dispositif de commande (1) servant à commander une unité d'affichage (3) en vue d'informer un conducteur d'un véhicule sur la capacité à débiter une puissance minimale d'un moteur électrique du véhicule pouvant être requise par le conducteur, avec un ordinateur (2), avec une première interface (11) avec l'unité d'affichage (3), avec une deuxième interface (12) avec un accumulateur d'énergie (4) d'un moteur électrique de véhicule, le dispositif de commande (1) commandant l'unité d'affichage (3) de telle sorte qu'un affichage de l'élément d'affichage (100, 101, 102, 103, 110, 111, 112, 140, 142) peut varier en fonction de la puissance minimale pouvant être requise par le moteur électrique sur une durée pouvant être prédéfinie, **caractérisé en ce que** le dispositif de commande (1) est configuré de telle sorte que la puissance minimale pouvant être requise ne peut être requise par instruction du conducteur que lorsque la puissance minimale pouvant être requise peut être mise à disposition pendant au moins la durée prédéfinie.

7. Dispositif de commande selon la revendication 6, **caractérisé en ce que** le dispositif de commande (1) comporte une troisième interface (13) avec une unité de saisie (5) permettant au conducteur de requérir une puissance minimale du moteur électrique.
